# EUROPÄISCHE PATENTANMELDUNG

(11) **EP 0 855 747 A1**
(43) Veröffentlichungstag der Anmeldung: **29.07.1998**
(21) Anmeldenummer: 98100638.0
(22) Anmeldetag: 15.01.1998
(51) Int. Cl.: H01L 29/423, H01L 21/8228, H01L 29/417, H01L 27/06, H01L 21/331

(54) **Vertikaler pnp-Transistor**

(30) Priorität: 23.01.1997 DE 19702320
(71) Anmelder: SIEMENS AKTIENGESELLSCHAFT, 80333 München (DE)
(72) Erfinder: Lachner, Rudolf, 85051 Ingolstadt (DE); Bianco, Michael, Dr., 81737 München (DE)

(57) **Zusammenfassung**

Der vertikale pnp-Transistor ist dadurch gekennzeichnet, daß der vorzugsweise aus einer n-Polysiliziumschicht gebildete Basiskontakt (10) nach dem aus einer p-Polysiliziumschicht gebildeten Emitterkontakt (6) hergestellt wird und dadurch zumindest teilweise oberhalb des Emitterkontaktes liegt. Bei Integration mit einem vertikalen npn-Transistor wird aus derselben p-Polysiliziumschicht der Emitterkontakt (6) des pnp und der Basiskontakt (61) des npn hergestellt. Der pnp-Transistor besitzt einen geringen Platzbedarf und ist einfach herstellbar.

## Beschreibung

Die Erfindung betrifft einen vertikalen Transistor nach dem Oberbegriff des Patentanspruchs 1.

Elektrische Schaltungen, insbesondere solche für Analoganwendungen, benötigen neben npn- auch pnp-Transistoren. pnp-Transistoren können in integrierten Schaltkreisen in lateraler oder vertikaler Bauweise realisiert werden. Bei der Herstellung von lateralen pnp-Transistoren in Bipolar- oder BiCMOS-Schaltkreisen werden i.d.R. aus Kostengründen Prozeßschritte benutzt, die zur Realisierung anderer Bauelemente, z.B. des npn-Transistors, verwendet werden (H. Klose, R Lachner, K.R. Schön, R. Mahnkopf, K.H. Malek, M. Kerber, H. Braun, A.v. Felde, J. Popp, O. Cohrs, E. Bertagnolli, P. Sehrig 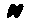 B6HF: A 0.8 Micron 25GHz/25ps BIPOLAR Technology for 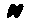 Mobile Radio" and 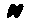 Ultra Fast Data Link" IC-Products", Proc. Bipolar Circuits Tech. Meet. 1993, pp. 125-127). Die Geschwindigkeit dieses lateralen Bauelements ist im Vergleich zu vertikalen Transistoren niedrig, da seine Basisweite durch die Fotolithographie bestimmt wird und daher groß ist. Ferner ist der Flächenverbrauch des lateralen Transistors groß. Vertikale pnp-Transistoren, deren Aufbau dem vertikaler npn-Transistoren mit umgekehrter Dotierung entspricht, zeichnen sich zwar durch hohe Geschwindigkeit und geringen Flächenverbrauch aus, benötigen aber eine große Anzahl zusätzlicher Prozeßschritte. Ihre Herstellung ist daher aufwendig und teuer (P.-F. Lu, J.D. Warnock, J.D. Cressler, K.A. Jenkins, K.-Y. Toh 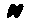 The Design and Optimization of High-Performance, Double-Poly Self-Aligned p-n-p Technology", IEEE Tans. Electron Devices, vol. ED-38, no 6, pp. 1410-1418).

Aufgabe der vorliegenden Erfindung ist es daher, einen vertikalen pnp-Transistor anzugeben, der einfach herstellbar ist und insbesondere bei Integration mit einem vertikalen npn-Transistor den Prozeßaufwand nicht oder nur unwesentlich erhöht. Ferner soll ein entsprechendes Herstellverfahren angegeben werden. Diese Aufgabe wird durch die Merkmale der Patentanspruch 1 bzw. 11 gelöst.

Grundidee der Erfindung ist die Herstellung des auf der Substratoberfläche angeordneten Emitterkontaktes vor der Herstellung des Basiskontaktes bei Verwendung einer selbstjustierten Anordnung dieser Kontakte mittels einer Spacer-Isolation. Der Basiskontakt erstreckt sich daher zumindest teilweise über diesen Spacer und den Emitterkontakt.

Der Emitterkontakt wird aus einer p-dotierten Polysiliziumschicht gebildet, der Emitter wird durch Ausdiffusion des Dotierstoffs (Bor) aus dem p-Polysilizium in das Substrat gebildet. Der Emitter kann ringförmig um die Basis oder in Streifen beidseitig der Basis verlaufen. In einer anderen Ausführungsform kann er als Streifen an nur einer Seite der Basis verlaufen. Der Basiskontakt besteht vorzugsweise aus n-Polysilizium wobei durch Ausdiffusion in das Substrat ein Basis-Anschlußgebiet erzeugt wird. Er kann aber auch beispielsweise aus Wolfram hergestellt werden.

Der pnp-Transistor kann in einem n- oder p-dotierten Halbleitersubstrat angeordnet sein, wobei das Halbleitersubstrat eine epitaktische Schicht aufweisen kann. Zur Isolation von benachbarten Bauelementen kann beispielsweise eine STI-Trench-Isolation eingesetzt werden.

Der pnp-Transistor läßt sich besonders einfach gleichzeitig mit einem vertikalen npn-Transistor herstellen, wenn dieselbe p-dotierte Polysiliziumschicht zur Bildung des Emitterkontaktes des pnp-Transistors und des Basiskontaktes des npn-Transistors verwendet wird. Vorzugsweise wird anschließend dieselbe n-dotierte Polysiliziumschicht zur Bildung des Basiskontakts des pnp-Transistors und des Emitterkontaktes des npn-Transistors verwendet. Auch die Integration mit einem CMOS-Prozeß (BICMOS) ist ohne oder mit nur geringem Mehraufwand möglich. Beispielsweise kann die Basis gleichzeitig mit einer n-LDD- oder einer n-Wannen-Implantation hergestellt werden.

Weitere wesentliche Vorteile des pnp-Transistors sind seine hohe Geschwindigkeit aufgrund der geringen Basisweite und sein geringer Flächenbedarf. Bei gleichzeitiger Herstellung eines npn-Transistors ergibt sich gegenüber einem konventionellen Aufbau des pnp (mit in allen Bereichen gegenüber npn vertauschten Dotierungen) der Vorteil, daß das Polysilizium ganzflächig dotiert werden kann und nicht im pnp-Bereich entgegengesetzt dotiert werden muß wie im npn-Bereich. Es ist also eine in-situ-Dotierung anstelle der undotierten Abscheidung mit anschließender Dotierung (bspw. durch Implantation) möglich. In-situ-dotierte Polysiliziumschichten haben bessere Eigenschaften, insbesondere bieten sie bei sehr kleinen Emitterfenstern, wie sie für Hochfrequenzanwendungen typisch sind, ein wesentlich verbessertes Ausdiffusionsverhalten.

Die Erfindung wird im folgenden anhand von Ausführungsbeispielen, die in den Zeichnungen dargestellt sind, näher erläutert. Es zeigen
- FIG 1:: einen Querschnitt durch ein Halbleitersubstrat mit einem pnp-Transistor gemäß eines ersten Ausführungsbeispiels
- FIG 2 bis 6:: weitere Ausführungsbeispiele

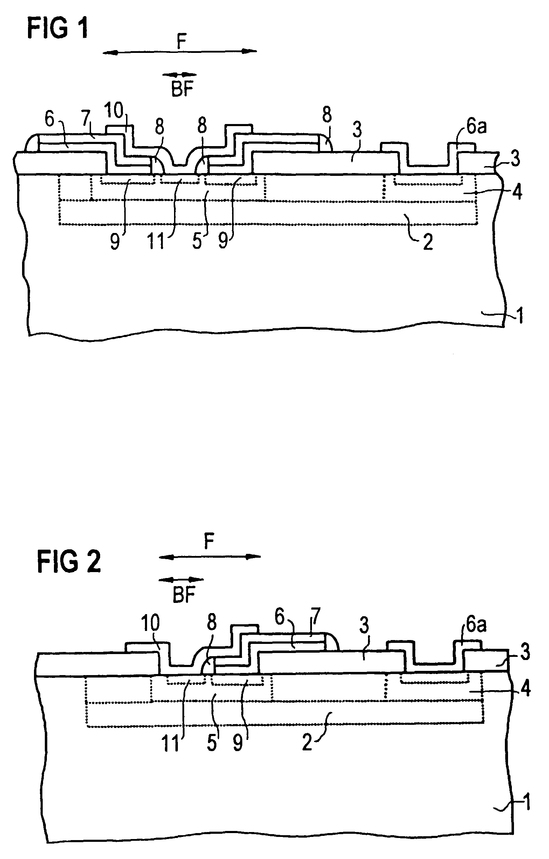

FIG 1: Der vertikale pnp-Transistor wird anhand eines Herstellverfahrens im Rahmen eines BICMOS-Prozesses beschrieben. Dabei sind nur die Schritte aufgeführt oder näher erläutert, die der Herstellung des pnp-Transistors dienen.
In einem n-dotierten Halbleitersubstrat 1 wird ein vergrabener p-dotierter Bereich 2 als Kollektor hergestellt, beispielsweise durch eine geeignete Hochenergieimplantation oder durch Dotierung und anschließendes Aufbringen einer n-dotierten epitaktischen Schicht (1a in FIG 6). Dann werden Isolationsgebiete 3 erzeugt, die der Isolation benachbarter Bauelemente oder zwischen den herzustellenden Kollektoranschluß und dem aktiven Emitter/Basis-Gebiet dienen. Die Isolationsgebiete 3 können beispielsweise LOCOS-oder Shallow-Trench-Gebiete sein. Anschließend wird ein Kollektoranschlußgebiet 4 mittels p-Implantation hergestellt. Mit derselben Implantation kann beispielsweise ein p-Wanne der CMOS-Transistoren hergestellt werden.

Mit einer weiteren Maske wird eine n-Implantation durchgeführt, mit der ein n-dotierter Bereich als Basis 5 gebildet wird. Dies kann beispielsweise gleichzeitig mit einer n-LDD- oder n-Wannen-Implantation im CMOS-Bereich erfolgen. Die Justierung dieser Maske ist für den pnp-Transistor unkritisch, da die äußere Begrenzung für die Implantation durch das Fenster F zwischen den Isolationsgebieten 3 bestimmt wird.

Nachfolgend werden eine p-dotierte Polysiliziumschicht 6 und eine Isolationsschicht 7 vorzugsweise aus TEOS aufgebracht und gemeinsam strukturiert, so daß diese Doppelschicht 6, 7 nur einen Teil des Fensters F bedeckt. Die p-Polysiliziumschicht 6 bildet den Emitterkontakt und verläuft beispielsweise ringförmig oder streifenförmig an den LOCOS-Kanten. Die Anordnung ist unempfindlich gegenüber einer Dejustierung der Maske zur Strukturierung der p-Polysiliziumschicht 6, da die Gesamtfläche des späteren Emitters 9 dadurch nicht verändert wird. Vorzugsweise wird aus derselben p-Polysiliziumschicht 6 auch ein Kollektorkontakt 6a hergestellt. Beim npn-Transistor wird aus der p-Polysiliziumschicht der Basiskontakt 60 (siehe Figur 5) wie bekannt strukturiert. Durch Ausdiffusion in das Substrat wird der Emitter 9 gebildet.

An den freiliegenden Seiten der p-Polysiliziumschicht 6 werden isolierende Spacer 8 hergestellt, vorzugsweise aus einem CVD-Siliziumoxid. Die verbleibende freie Substratoberfläche stellt ein Fenster BF für den Basiskontakt dar (bzw. beim npn-Transistor ein Emitterfenster). Es wird eine n-dotierte Polysiliziumschicht aufgebracht und zu einem Basiskontakt 10 strukturiert, der mindestens die freiliegende Substratoberfläche vollständig bedeckt. Durch Ausdiffusion wird ein Basisanschlußgebiet 11 im Substrat gebildet. Die gleichzeitige Herstellung eines npn-Transistors ist besonders einfach, wenn auf dieser n-Polysiliziumschicht der npn-Emitterkontakt 101 gebildet wird, der durch Ausdiffusion einen Emitter 111 im Substrat erzeugt. In einen BICMOS-Prozeß kann eine der dotierten Polysiliziumschichten beispielsweise als Wortleitungsebene eingesetzt werden.

Die weiteren Schritte werden konventionell durchgeführt: Die Anordnung wird mit einer isolierenden Schicht bedeckt, in die Kontaktlöcher insbesondere zum Basiskontakt 10, zum Emitterkontakt 6 und zum Kollektorkontakt 6a eingebracht werden. Schließlich folgt eine Metallisierung.

FIG 2: In einer zweiten Ausführungsform, bei der dieselben Bezugszeichen wie in FIG 1 gewählt wurden, besteht der Emitter 9 lediglich aus einem Streifen, d.h. der Emitter grenzt nur an einer Seite an das ausdiffundierte Basisanschlußgebiet 11. Dieser pnp-Transistor hat einen besonders geringen Platzbedarf, die Emitterfläche variiert aber bei einer Dejustierung der p-Polysiliziumätzmaske. Das Herstellverfahren unterscheidet sich vom zuvor erläuterten lediglich in einer entsprechend angepaßten Maske zur Strukturierung des Emitterkontaktes 6.

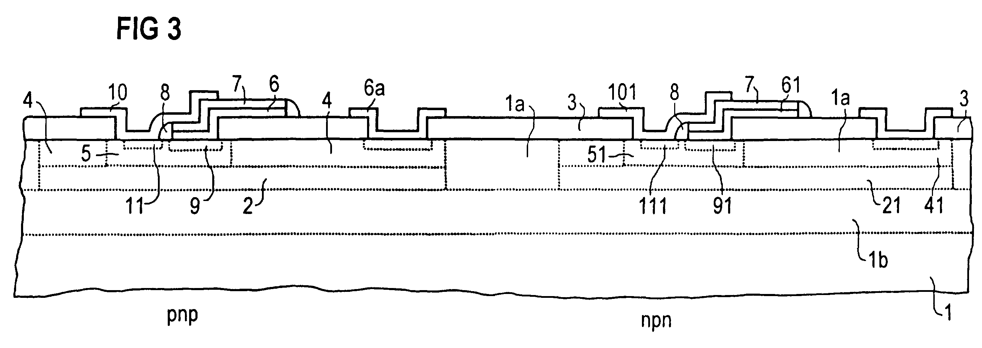

FIG 3: Wie erläutert, ist der vertikale pnp-Transistor besonders einfach mit einem konventionellen vertikalen npn-Transistor integrierbar, z.B. in einem p-Substrat 1 mit n-Epi-Schicht 1a. Im npn-Bereich werden ein Kollektor 21, ein Kollektoranschluß 41 und eine Basis 51 in bekannter Weise hergestellt, bei einem BICMOS-Prozeß kann dies gleichzeitig mit einer n-Wannenimplantation (für den Kollektoranschluß 41) bzw. einer p-LDD- oder p-Wannen-Implantation (für Basis 51) erfolgen. Aus der p-dotierten Polysiliziumschicht wird der Basiskontakt 61, aus der n-dotierten Polysiliziumschicht wird der Emitterkontakt 101 hergestellt, durch Ausdiffusion wird ein Emitter 111 erzeugt.
Beispielhafte Prozeßfolge für einen derartigen BICMOS-Prozeß:
- P-Substrat (Ausgangsmaterial)
- Tiefer n-Buried Layer 1b (Isolation der p-Buried Layer gegen das p-Substrat), z.B. Phosphor-Implantation 120keV und nachfolgende Diffusion 1100°
- n-Buried Layer (= Kollektor 21 npn-Transistor), z.B. Arsen-Implantation 100keV und nachfolgende Diffusion 1000° p-Buried Layer (= Kollektor 2 pnp-Transistor), z.B. Bor-Implantation und nachfolgende Diffusion 950°
- Epitaxie z.B. 1µm, Arsen-dotiert 1a, dient auch dem Kollektoranschluß 41 des npn
- LOCOS-Isolation (für CMOS- und Bipolar-Bauelemente)
- Kollektoranschlußimplantation 41 für npn-Transistor (hochdotiertes Gebiet zwischen Kollektorkontakt und n-Buried Layer 21) z.B. Phosphor-Implantation 120keV und nachfolgende Diffusion 1000°
- pWannen- und Kanal-Implantationen NMOS (mit Lackmaske), z.B. Bor-Implantation 40keV und Bor-Implantation 300keV, wird für Kollektoranschluß 4 genutzt
- nWannen- und Kanal-Implantationen PMOS (mit Lackmaske), z.B. Arsen-Implantation 400keV und Phosphor-Implantation 500keV
- Gate-Poly-Abscheidung, -Dotierung (z.B. POCl₃-Belegung und Diffusion 900°) und -Strukturierung
- p-LDD-Implantation (mit Lackmaske), z.B. Bor-Implantation 25keV
- n-LDD-Implantation (mit Lackmaske), z.B. Phosphor-Implantation 120keV
   Diese Implantation wird auch als Basis 5 für den pnp-Transistor genutzt
- p-Source/Drain-Implantation (mit Lackmaske), z.B. Bor-Implantation 25keV
- n-Source/Drain-Implantation (mit Lackmaske), z.B. Arsen-Implantation 120keV
- Kapazität: Herstellung des Dielektrikums (z.B. CVD-Nitrid-Abscheidung) und Strukturierung
- Poly 1 (p-Poly) (=Basisanschluß 61 für npn-Transistor und Emitteranschluß 6 für pnp-Transistor): Abscheidung, ganzflächige p-Dotierung (ohne Lackmaske, z.B. Bor-Implantation 15keV), Abscheidung eines CVD-Oxids 7 (elektrische Isolation des Poly 1 gegen Poly 1), Strukturierung beider Schichten
- Basisimplantation 51 npn (mit Lackmaske), z.B. BF₂-Implantation 25 keV
- Spacerherstellung 8 (Abscheidung und anisotrope Rückätzung einer oder mehrerer Schichten zur Bildung eines elektrisch isolierenden Ätzresiduums an den Poly 1-Kanten) z.B. CVD-Oxid-Abscheidung und Rückätzung
- Poly 2 (n-Poly) (=Basisanschluß 10 für pnp-Transistor und Emitteranschluß 101 für npn-Transistor): Abscheidung, ganzflächige n-Dotierung durch Implantation (ohne Lackmaske) z.B. Arsen 30keV und Strukturierung
- Temperung: Diffusion der in den Poly-Schichten enthaltenen Dotierstoffe in das Substrat (Bildung der Emitter 111, 9 und Basisanschlußkontakte 91, 11 der npn- und pnp-Transistoren), z.B. Diffusion 950°
- Metallisierung (Zwischenoxid, Planarisierung, Kontaktlochätzung, Metall 1, Passivierung, Pads)

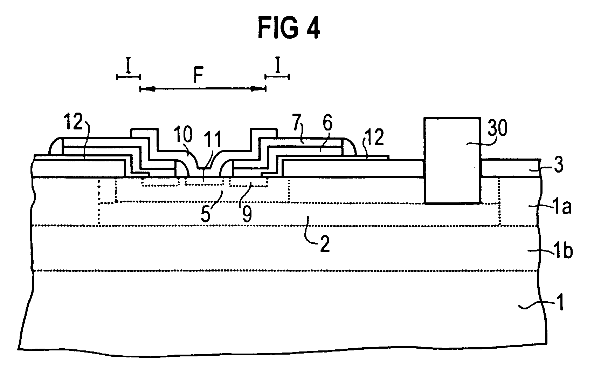

FIG 4: Der pnp-Transistor kann auch in einem Halbleitersubstrat 1 mit einer epitaktischen Schicht 1a hergestellt werden. Beispielsweise ist das Substrat p-dotiert und die epitaktische Schicht n-dotiert. Bei einer Anordnung des Transistors in einem p-dotierten Substrat oder in einem Substrat 1 mit einer p-dotierten epitaktischen Schicht 1a ist die Isolation zwischen Emitter 9 und Kollektoranschluß 4 (vgl. FIG 1) durch die den Emitter 9 umschließende Basis 5 gewährleistet. Die Isolation gegenüber dem Substrat 1 kann durch einen tiefen n-dotierten Buried layer 1b erfolgen.

In der FIG ist ferner eine weitere Schicht 12 dargestellt, mit deren Hilfe die äußere Begrenzung des Emitter-/Basis-Fensters F definiert wird. Diese weitere Schicht 12 ist auf dem Isolationsgebiet 3 angeordnet; dazu kann beispielsweise ein Dielektrikum benutzt werden, wie es in dem oben angegebenen Artikel von Klose et al. und in der Beschreibung zu FIG 3 nach der Feldisolation und vor der p-Polysilizium-Abscheidung als Kondensatordielektrikum hergestellt wird. Die weitere Schicht 12 wird so strukturiert, daß sie sich über das Isolationsgebiet 3 hinaus auf die freie Oberfläche erstreckt und so das Fenster F verkleinert. Dadurch wird der Isolationsabstand I im Substrat erhöht.

Weiter können der Transistor bzw. das Herstellverfahren unter anderem folgendermaßen variiert werden:
a) Je nach Prozeß, in dem der vertikale pnp-Transistor integriert wird, können die dotierten Bereiche im Substrat (Basis 5, Kollektor 2, Kollektoranschlußgebiet 4) auch durch andere Prozeßschritte wie beispielsweise Source-Drain-Implantationen hergestellt werden.
b) Zur Einstellung optimaler elektrischer Eigenschaften kann für die Dotierung der Basis 5 statt eines vorhandenen ein zusätzlicher Herstellungsschritt verwendet werden. Dabei kann z. B. einem mittels Lackmaske definierten Bereich der Basis Phosphor oder Arsen implantiert werden. Ferner ist dann eine sogenannte Podestimplantation mit Bor, die die Geschwindigkeit der Schaltung erhöht, möglich.
c) Der Kollektorkontakt aus p-Polysilizium 6a kann entfallen ein Anschluß direkt auf dem Substrat realisiert werden.
d) Der Kollektorkontakt kann auch ohne die Verwendung des p-Polysilizium 6a und des Kollektoranschlußgebietes 4 angeschlossen werden, wenn vor der Metallisierung eine Ätzung durchgeführt wird, die das Siliziumsubstrat 1 im Bereich des Kollektoranschlusses bis auf den vergrabenen Kollektor 2 abträgt. Die Metallisierung 30 beispielsweise aus Wolfram kontaktiert dann den vergrabenen Kollektor direkt (in FIG 4 dargestellt).
e) Der vergrabene Kollektor kann mit Hilfe zweier Kollektoranschlußgebiete kontaktiert werden, insbesondere da bei Bor-Dotierung die Gefahr eines höheren Schichtwiderstandes des vergrabenen Kollektors größer ist als bei einer Arsen- oder Phosphordotierung.

## Patentansprüche

1. Vertikaler pnp-Transistor in einem Halbleitersubstrat (1) mit einem vergrabenen p-dotierten Bereich als Kollektor (2), mit einem n-dotierten Bereich als Basis (5) und einem auf der Substratoberfläche angeordneten Basiskontakt (10), und mit einem p-dotierten Bereich als Emitter (9) und einer p-dotierten Polysiliziumschicht auf der Substratoberfläche als Emitterkontakt (6),
**dadurch gekennzeichnet,** daß
der Basiskontakt (10) zumindest teilweise oberhalb des Emitterkontaktes (6) angeordnet ist.

2. Transistor nach Anspruch 1,
**dadurch gekennzeichnet,** daß
der Basiskontakt (10) aus n-dotiertem Polysilizium besteht.

3. Transistor nach einem der Ansprüche 1 bis 2,
**dadurch gekennzeichnet,** daß
der Emitterkontakt (6) ringförmig um den Basiskontakt (10) angeordnet ist.

4. Transistor nach einem der Ansprüche 1 bis 3,
**dadurch gekennzeichnet,** daß
der Emitterkontakt (6) streifenförmig neben dem Basiskontakt (10) angeordnet ist.

5. Transistor nach einem der Ansprüche 1 bis 4,
**dadurch gekennzeichnet,** daß
der Kollektor (2) über ein Kollektoranschlußgebiet (4) mit einem auf der Substratoberfläche angeordneten Kollektorkontakt (6a) aus p-Polysilizium oder mit einem Metall oder Refraktärmetall (30) verbunden ist.

6. Transistor nach einem der Ansprüche 1 bis 4,
**dadurch gekennzeichnet,** daß
der vergrabene Kollektor (2) direkt mit einem Metall oder Refraktärmetall (30) verbunden ist.

7. Transistor nach einem der Ansprüche 1 bis 6,
**dadurch gekennzeichnet,** daß
der Kollektor (2) an mindestens zwei Stellen von außen anschließbar ist.

8. Transistor nach einem der Ansprüche 1 bis 7,
**dadurch gekennzeichnet,** daß
der der laterale Abstand zwischen Emitterkontakt (6) und Basiskontakt (10) durch einen Spacer (8) definiert ist.

9. Transistor nach einem der Ansprüche 1 bis 8,
**dadurch gekennzeichnet,** daß
die äußere Kante des Emitter-/Basisfensters (F) durch ein Isolationsgebiet (3) definiert ist, das der Isolation zu benachbarten Bauelementen oder zum Kollektorkontakt dient.

10. Transistor nach einem der Ansprüche 1 bis 8,
**dadurch gekennzeichnet,** daß
die äußere Kante des Emitter-/Basisfensters (F) durch eine weitere Schicht (12) definiert ist, die auf einem Isolationsgebiet (3) angeordnet ist, das der Isolation zu benachbarten Bauelement oder zum Kollektorkontakt dient.

11. Herstellverfahren für einen vertikalen pnp-Transistor mit einem vergrabenen p-dotierten Bereich als Kollektor (2), mit einem n-dotierten Bereich als Basis (5) und einem auf der Substratoberfläche angeordneten Basiskontakt (10), und mit einem p-dotierten Bereich als Emitter (9) und einer p-dotierten Polysiliziumschicht auf der Substratoberfläche als Emitterkontakt (6),
**dadurch gekennzeichnet,** daß
der Emitterkontakt (6) vor dem Basiskontakt (10) hergestellt wird.

12. Herstellverfahren nach Anspruch 11,
**dadurch gekennzeichnet,** daß
der Emitterkontakt (6) durch eine auf ihm angeordnete isolierende Schicht (7) und durch einen seitlich an ihm angeordneten Spacer (8) von dem Basiskontakt (10) isoliert wird.

13. Herstellverfahren nach einem der Ansprüche 11 bis 12,
**dadurch gekennzeichnet,** daß
der Basiskontakt (10) aus einer n-dotierten Polysiliziumschicht gebildet wird.

14. Halbleiterschaltung in einem Halbleitersubstrat (1) umfassend
- einen vertikalen npn-Transistor mit einem vergrabenen n-dotierten Bereich als Kollektor (21), einen p-dotierten Bereich als Basis (51) und einer p-dotierten Polysiliziumschicht auf der Substratoberfläche als Basiskontakt (61), und einem n-dotierten Bereich als Emitter (111) und einer n-dotierten Polysiliziumschicht auf der Substratoberfläche als Emitterkontakt (101),
- und einen vertikalen pnp- Transistor nach einem der Patentansprüche 2 bis 10,
- bei der der Basiskontakt (61) des npn-Transistors und der Emitterkontakt (6) des pnp-Transistors aus derselben p-Polysiliziumschicht gebildet sind.

15. Schaltung nach Anspruch 14, bei der der Emitterkontakt (101) des npn-Transistors und der Basiskontakt (10) des pnp-Transistors aus derselben n-Polysiliziumschicht gebildet sind.

16. Herstellverfahren für eine Halbleiterschaltung in einem Halbleitersubstrat (1) umfassend
- einen vertikalen npn-Transistor mit einem vergrabenen n-dotierten Bereich als Kollektor (21), einen p-dotierten Bereich als Basis (51) und einer p-dotierten Polysiliziumschicht auf der Substratoberfläche als Basiskontakt (61), und einem n-dotierten Bereich als Emitter (111) und einer n-dotierten Polysiliziumschicht auf der Substratoberfläche als Emitterkontakt (101),
- und einen vertikalen pnp- Transistor nach einem der Patentansprüche 2 bis 10,
**dadurch gekennzeichnet,** daß
der Basiskontakt (61) des npn-Transistors und der Emitterkontakt (6) des pnp-Transistors aus derselben p-Polysiliziumschicht hergestellt werden.

17. Herstellverfahren nach Anspruch 16, bei dem der Emitterkontakt (101) des npn-Transistors und der Basiskontakt (10) des pnp-Transistors aus derselben n-Polysiliziumschicht hergestellt werden.

18. Herstellverfahren nach einem der Ansprüche 16 bis 17, bei dem die p-dotierte Polysiliziumschicht und/oder die n-dotierte Polysiliziumschicht als in-Situ-dotierte Schichten hergestellt werden.
